# EUROPEAN PATENT APPLICATION

(11) **EP 1 608 209 A1**
(43) Date of publication of application: **21.12.2005**
(21) Application number: 05013161.4
(22) Date of filing: 17.06.2005
(51) Int. Cl.: H05K 1/16, C25D 3/56

(54) **Conductive base material with resistance layer and circuit board material with resistance layer**

(30) Priority: 17.06.2004 JP 2004179797
(71) Applicant: FURUKAWA CIRCUIT FOIL CO., LTD., Tokyo 101-0054 (JP)
(72) Inventor: Kikuchi, Yuuki Furukawa Circuit Foil Co., Ltd., Imaichi-city Toichigi-ken 321-2336 (JP); Matsuda, Akira Furukawa Circuit Foil Co., Ltd., Imaichi-city Toichigi-ken 321-2336 (JP); Suzuki, Yuuji Furukawa Circuit Foil Co., Ltd., Imaichi-city Toichigi-ken 321-2336 (JP); Matsumoto, Sadao Furukawa Circuit Foil Co., Ltd., Imaichi-city Toichigi-ken 321-2336 (JP)
(74) Representative: Rupp, Christian

(57) **Abstract**

A conductive base material with resistance layer provided with roughened conductive base material on the surface of which the resistance layer is formed with uniform thickness distribution, and a resistance circuit board material using the same, wherein electrodeposited copper foil having granular crystals is roughening treated on at least one surface to obtain Rz of not more than 2.5 µm and the resistance layer of Ni alloy layer containing at least 8 to 18 wt% of P is formed on the roughening treated side.

## Description

### BACKGROUND OF INVENTION

### 1. Field of Invention

The present invention relates to a conductive base material with resistance layer useful for producing printed resistance circuit board, more particularly relates to a conductive base material with resistance layer having superior stability of resistance value and featuring little fluctuation in resistance at the time of etching off copper foil or other processing and to a circuit board material with resistance layer using the same.

### 2. Description of Related Art

A printed circuit board material with built-in resistors (hereinafter referred to as "resistance circuit board material") is generally brought in form of a stack of insulation board and conductive base material with resistance layer having the resistance layer bonded on the board and copper foil or another highly conductive base material bonded to the resistance layer.

The printed resistance circuit using the resistance circuit board material is formed by subtractive process (mask etching process) with insulation regions where the entire resistance layer and conductive base material on the insulation board are removed, resistance regions where the highly conductive base material is removed, and conductive regions where the entire layer is left according to desired circuit pattern.

In related art, carbon-based resistance material is generally used as the material for forming the resistance layer. Additionally, metal thin film may be used. For example, Japanese Unexamined Patent Publication (Kokai) No. 48-73762 and Japanese Examined Patent Publication (Kokoku) No. 63-500133 disclose electroplating of nickel containing phosphorus, and Japanese Unexamined Patent Publication (Kokai) No. 54-72468 discloses electroplating of nickel containing tin. With such types of metal thin film resistance layers, it is possible to reduce the thickness to obtain film with high sheet resistance. However, when the thickness is reduced, the metal film loses its uniformity and constant sheet resistance cannot be obtained. Consequently, there has been a limit to the thinness of metal film.

When using roughened electrodeposited copper foil having large surface roughness by columnar crystals and plating it for resistance layer, the surface of the copper foil is so rough that the actual surface area of copper foil becomes larger than apparent surface area and the variation of surface area becomes large. Therefore, the resistance value fluctuates within the copper foil. Since the plating thickness of resistance layer becomes unstable, board material with resistance layer having constant sheet resistance (copper foil with resistance layer) could not be produced.

On the other hand, in the case of dissolving copper foil layer by etching to form the circuit using copper foil with resistance layer of low etching factor (formation of resistance regions), the copper foil will end up with inwardly sloped sides in its cross-sectional shape. Consequently, the copper foil layer may remain partly on the resistance layer.

Also, resistance circuits with variable resistance values are frequently required in the same board. The widths and lengths of the resistors of the conductive base material with resistance layer are adjusted by etching. Therefore, it is preferable to form thin coating film with a high resistance so as to reduce the influence of the etching. However, when forming such thin coating film on the surface of copper foil having columnar crystals, the rough side of the copper foil results in larger actual surface area leading to smaller actual plating thickness. On the other hand, when forming the resistance layer thin, the coating film sometimes becomes discontinuous and the local difference in the resistance value becomes larger.

On the other hand, conductive base material with a resistance layer, especially copper foil with resistance layer, is produced by forming a thin film resistance layer on the surface of electrodeposited copper foil by electroplating. In order to improve the bonding strength of the conductive base material with the resistance layer to the insulation board, electrodeposited copper foil having large roughness side with columnar crystal is used, the foil surface is roughened, and Ni-P resistance layer is plated to raise the bonding strength. However, with such a method, the resistance layer is formed thick on the projecting portions of relief patterns of electrodeposited copper foil surface having columnar crystal side and relief patterns of the sparse roughing particles leading to poor distribution of resistance layer thickness. The thinner the resistance layer, the poorer thickness distribution and it results in unevenness of the sheet resistance.

Further, when etching away parts of the layer of the conductive base material to use as resistance circuit board material, parts of the resistance layer are unavoidably dissolved. In particular, if the thickness of Ni-P plating resistance layer varies, part of resistance circuits may be missed along with partial dissolution of the resistance layer. Therefore, it is difficult to produce printed resistance circuit board stably leaving the resistance circuits (resistance elements).

Further, the printed resistance circuit boards are hot pressed when producing printed resistance circuit boards stacked in large number of layers. Due to difference in thermal expansion coefficient between the board and the resistance layer, the resistance layer cannot expand enough to keep up with the expansion of board resulting in crack which causes increased resistance and broken circuits.

In the case of using Ni-Sn alloy as the resistance layer, oxide or hydroxide of Sn remains on the insulation board at the time of etching of resistance layer (Ni-Sn dissolution) to form the insulation regions. As a result, poor insulation may be caused.

Further, Ni-Cr, Ni-Cr-Al-Si, and other alloys for resistance layers by vapor deposition are being developed for the same purpose, but disadvantages of cost and productivity and low bonding strength with the insulation material have been pointed out.

### SUMMARY OF THE INVENTION

The object of present invention is to provide a conductive base material with resistance layer maintaining bonding strength with insulation material and having thin film resistance layer with stable resistance after circuit formation by etching and a circuit board material with resistance layer using the same.

According to the first aspect of present invention, there is provided a conductive base material with resistance layer having electrodeposited copper foil having granular crystals and roughening treated on at least one surface to Rz of not more than 2.5 µm and resistance layer of Ni alloy containing at least 8 to 18 wt% of P formed on the roughening treated side.

Preferably, the thickness of resistance layer of Ni alloy is 0.1 to 20 mg/dm² in weight conversion.

According to the second aspect of present invention, provided is a circuit board material with resistance layer having conductive base material with resistance layer including electrodeposited copper foil having granular crystals and roughening treated on at least one surface to Rz of not more than 2.5 µm and resistance layer of Ni alloy containing at least 8 to 18 wt% of P formed on the roughening treated side and insulation board to at least one surface of which the base material is bonded with the resistance layer at inside.

Preferably, the thickness of the resistance layer of the Ni alloy is 0.1 to 20 mg/dm² in weight conversion.

### DESCRIPTION OF PREFERRED EMBODIMENTS

According to the present embodiment, provided is a conductive base material with resistance layer on electrodeposited copper foil having granular crystals and roughening treated on at least one surface to Rz of not more than 2.5 µm and resistance layer of Ni alloy containing at least 8 to 18 wt% of P formed on the roughening treated side.

That is, electrodeposited copper foil having granular crystals is roughening treated on at least one surface to Rz of not more than 2.5 µm, then formed with resistance layer of Ni alloy containing at least 8 to 18 wt% of P on the roughening treated side.

The electrodeposited copper foil has buff texture on its S side (drum-contacting side) due to electrodepositing drum and it is only sparsely rough even after roughening treated. Therefore, even if the sparsely roughened S side is plated with resistance layer, it may be difficult to obtain resistance layer having sheet resistance with uniform thickness and constant resistance value. Consequently, when roughening treating the S side, it is desirable to keep Rz of untreated electrodeposited copper foil at about 1 µm or smooth the foil by chemical polishing, electrolytic polishing, or other method.

On the other hand, in case of electrodeposited copper foil having granular crystals, unlike the case of columnar crystals, its M side which is opposite to S side (opposite to the drum-contacting side) is smooth and even, so the roughening treatment can be performed uniformly. Consequently, resistance layer having sheet resistance with uniform thickness and constant resistance value can be formed. Therefore, it is preferable that the resistance layer be formed on M side.

The electrodeposited copper foil should preferably have Rz of not more than 2.0 µm at least at the surface to be formed with the resistance layer.

Ni alloy containing Co, Cu, etc. as alloy components in addition to P may also be used.

The thickness of the Ni alloy layer composing the resistance layer is preferably 0.1 to 20 mg/dm² in weight conversion.

According to present embodiment, provided is a circuit board material with resistance layer having conductive base material with resistance layer and an insulation board to at least one surface of which the base material is bonded with the resistance layer at inside.

That is, the insulation board may have the conductive base material with the resistance layer bonded to its both surfaces as well.

According to the present invention therefore, it is possible to provide a conductive base material with resistance layer with small fluctuation of the resistance value and uniform appearance and a circuit board material with resistance layer able to form resistance circuits matching specific design values using the conductive base material with the resistance layer.

According to the circuit board material of present embodiment, it is possible to form superior resistance circuits with less fluctuation of the resistance values and no breakage of the resistance layer during processing compared with conductive base material with resistance layer using electrodeposited copper foil having columnar crystal side of the related art.

Namely, the surface of electrodeposited copper foil having columnar crystals forms columnar relief shapes of large surface roughness. Even if this rough side is roughening treated, only the projecting parts of the copper foil surface are roughening treated. Consequently such a roughening treated side is hardly plated to form uniform resistance layer. Also, when the surface of copper foil is rough, as described above, actual surface area becomes much larger than apparent surface area and the large variable difference makes the resistance value also locally variable and the plating thickness of the resistance layer becomes unstable. Therefore, it has been difficult to produce a circuit board material with resistance layer having constant sheet resistance.

On the other hand, the surface of electrodeposited copper foil having granular crystals is smooth and roughening treatment performed on copper foil surface is uniform. Consequently, the resistance layer is plated on the roughening treated side with even thickness. The actual surface area equals to the apparent surface area substantially. As a result, the circuit board material with resistance layer having more uniform resistance value, superior stability of plating thickness of resistance layer, and constant sheet resistance can be produced.

The plating bath for plating the surface of electrodeposited copper foil having granular crystals with resistance layer may be sulfuric acid bath, sulfamic acid bath, pyrophosphoric acid bath, etc. Free acids, Ni and other metal components, and P may also be added to the bath. Additionally, Co, Cu, etc. can be added.

P is added in form of hypophosphorous acid, phosphorous acid, phosphoric acid, and salts of the same.

Note that the plating conditions and the additives other than P are not limited to the above. Also, other well known baths can be used.

A method of producing conductive base material with resistance layer of the present invention will be described using sulfamic acid bath as an example. The concentrations of Ni and sulfamic acid may be in the ranges used for usual sulfamic acid plating baths. They are preferably 300 to 600 g/L as nickel sulfamate.

The hypophosphorous acid, phosphorous acid, or phosphoric acid usually added to the plating bath may be used in this case too, but it is also possible to replace it with Na salt of P. The P concentration at that time is preferably 20 to 150 g/L. However, considering prevention of crystallization when the facilities are not operating and at other times when the temperature of the baths dropped, the P concentration is preferably 20 to 100 g/L.

The pH of plating bath can be controlled by using Na salt etc. Also, the pH can be controlled by adding NaOH or other alkali or sulfamic acid. The higher the pH, the worse the uniformity of the plating film, so the pH is preferably not more than 6. Further, there is little fluctuation in pH at 4 or less, so the pH 4 or less is more preferred.

The plating bath may further contain boric acid or other pH buffering agent so as to increase the pH stability and stabilize the film composition and current efficiency.

The bath temperature is preferably 30 to 80°C for obtaining superior current efficiency and stability of P content (hereinafter referred to "P%").

The current density is preferably 1 to 30 A/dm². The current efficiency easily drops and the plating smoothness deteriorates when the current exceeds this range.

The anode may be an Ni, Ni-P alloy, or other soluble anode. However, the soluble anode dissolves and is consumed over long term plating resulting in change in the distance to cathode (conductive base material). Consequently, the overall distribution of the plating thickness is disturbed and the uniformity of the thickness is lowered. Additionally, the Ni concentration in the plating bath increases due to difference of current efficiency between the cathode and anode. Consequently, the plating bath has to be drained increasing cost. Therefore, it is preferable to use insoluble anode. Note that when using insoluble anode, the concentration of Ni in the plating bath decreases, so Ni has to be supplied. It is preferable to add nickel carbonate or other nickel compound.

The coating film as the resistance layer of Ni-P alloy containing 8 to 18 wt% of P gives high resistance and features good etchability. Particularly, Ni-P alloy containing 10 to 15 wt% of P gives superior base material having stable distribution of the resistance value and etchability and with less variation in resistance caused by dissolution after etching the conductive base material (copper foil). The P% of the coating film obtained depends on the bath and plating conditions. Among them, pH, type and concentration of P compound, bath temperature, and current density show strong influences. By determining these conditions in advance in accordance with the type of bath used, resistance layer having the desired Ni-P composition can be formed.

The thickness of resistance layer is preferably 0.1 to 20 mg/dm² in weight conversion. By controlling the P content and the thickness of resistance layer, the desired resistance value can be obtained. The thickness is preferably not less than 1 mg/dm² for securing stability of the resistance. If it is over 20 mg/dm², the resistance value lowers and the width of circuit has to be made very narrow in order to obtain the desired resistance value.

It is also possible to include Cu, Co, or other element as an alloy component to be added to Ni other than P.

Note that, after the formation of resistance layer, the surface may also be suitably treated by Zn, chromate, silane, etc.

If the surface roughness of copper foil before plating is too large, the surface roughness of resistance layer formed on copper foil will also become large and it will be difficult to uniformly deposit the Ni alloy layer resulting in uneven plating thickness. During the hot-press after etching, the base material cracking will easily occur inside of the circuit board material with resistance layer due to stresses from the difference of thermal expansion coefficients concentrated at relief portions on the surface of the resistance layer. Therefore, the copper foil before plating preferably should have granular crystals and surface roughness Rz of not more than 2.5 µm. More preferably, in terms of processability, the surface roughness should not be more than 2.0 µm. In order to secure bonding strength with the insulation board, it is advantageous to have large roughness, but considering the thickness distribution of the resistance layer and uniform etching, the above range is preferred. More preferably, use electrodeposited copper foil having Rz of not more than 1.5 µm before roughening treatment.

The electrodeposited copper foil having granular crystal side used in the present embodiment is produced by electrodeposition using for example a copper sulfate electroplating solution made acidic by sulfuric acid, containing copper sulfate 5-hydrate in amount of 280 g/L, sulfuric acid in amount of 100 g/L, and Cl ions in amount of 35 ppm, into which is added low molecular weight gelatin with average molecular weight of 3000 in amount of 7 ppm, hydroxyethylcellulose in amount of 3 ppm, and sodium 3-mercapto-1-propanesulfonate in amount of 1 ppm under conditions of electrodeposition solution at 55°C, flow rate of 0.3 m/min, and current density of 50 A/dm².

On the other hand, copper foil having columnar crystals is produced by electrodeposition using, for example, copper sulfate electroplating solution made acidic by sulfuric acid, containing copper sulfate 5-hydrate in amount of 280 g/L, sulfuric acid in amount of 130 g/L, and Cl ions in amount of 50 ppm, into which is added hydroxyethylcellulose in amount of 10 ppm and sodium 3-mercapto-1-propanesulfonate in amount of 1 ppm under conditions of electrodeposition solution at 60°C, flow rate of 0.8 m/min, and current density of 45 A/dm².

Note that the conditions for formation of foils are not limited to the above.

An embodiment of method of producing the conductive base material with resistance layer will be described next.

First, the electrodeposited copper foil having granular crystals formed by the above method is roughening treated on its M side (opposite side to the drum-contacting side). The roughening treatment here includes roughening treating the surface of copper foil by burnt plating, then encapsulation-plating the burnt plated side. However, the roughening treatment is not limited to the above.

Before the roughening treatment, the entire S side is covered by masking adhesive sheet or ink etc. Next, the foil is burnt plated using the following:
Burnt plating solution composition
- Cu:: 20 to 35 g/L
- Sulfuric acid:: 110 to 160 g/L

Note that the burnt plating solution may further contain one or more of Mo, Ni, Fe, W, Co, As, or other metal.
Burnt plating conditions
- Current density:: 10 to 50 A/dm²
- Treatment time:: 2 to 15 sec

Next, the foil is encapsulation plated under the following conditions,
Encapsulation plating solution composition
- Cu:: 50 to 80 g/L
- Sulfuric acid:: 90 to 130 g/L
Encapsulation plating solution conditions
- Current density:: 10 to 30 A/dm²
- Treatment time:: 2 to 15 sec.

After the roughening treatment, the electrodeposited copper foil is formed on its M side with Ni alloy plating layer containing P as resistance layer. Then, the masking adhesive sheet or other covering is peeled off and the electrodeposited copper foil is bonded to the insulation board at its resistance layer side by hot-pressing, an adhesive, etc. to form a circuit board material with resistance layer.

The circuit board material with resistance layer is used to prepare a resistance circuit board material by, for example, dissolving (etching) parts away to form insulation regions where the entire resistance layer and conductive base material on the insulation board are dissolved away, resistance regions where only the highly conductive base material is dissolved away, and conductive regions where the entire layers are left to thereby form circuits. After the formation of the circuits, if necessary, the resistance regions and conductive regions are covered by liquid or film-like cover coating to form protective layer.

The dissolution can be performed using known etching solution. In the case of copper foil, ferric chloride, cupric chloride, ammonium persulfate, chromic acid and sulfuric acid mixture, or ammonia chelate-based etching solution may be used.

The etching solution used for Ni alloy resistance layer containing P may be solution of copper sulfate and sulfuric acid, solution of ferric sulfate and sulfuric acid, solution of ammonium persulfate and sulfuric acid, or other known etching solution.

The insulation board used may be made of epoxy resin, polyester, polyimide, polyamide-imide, composites of these with glass fabric, phenol resin and paper, epoxy resin and paper, and other laminates, etc. Further, a heat sink made of aluminum or steel sheet bonded to any of the above various insulating laminates, sheets, or films (at the opposite sides to the sides where the resistance layers are provided) may be used.

The insulation board used may be made of ceramic board, glass board, or other inorganic material using epoxy resin, polyester, polyurethane, polyamide-imide, polyimide, rubber, or other resin or rubber as adhesive.

In the above description of the circuit board material with resistance layer, for simplification, structure having insulation board on one surface of which the resistance layer and conductive base material were bonded was described, but the circuit board material with resistance layer according to the present embodiment can be modified and changed in structure as well and includes for example structure having insulation board on both surfaces of which resistance layers and conductive base materials are bonded and structure having insulation board on one surface of which resistance layer and conductive base material are bonded and on the other surface of which highly conductive layer is bonded for forming conductors and/or electrodes after etching.

The present embodiment relates to conductive base material with resistance layer and circuit board material with resistance layer having that conductive base material with resistance layer bonded to insulation board. In general, circuit board material with resistance layer used for printed circuit board etc. is provided with three layers of insulation board, resistance layer and conductive layer, but the present invention also includes circuit board material having over three layers. Further, of course, circuit board material with resistance layer obtained by stacking a number of these is also included.

The above description was made for the purpose of describing the invention in general and has no limitative meaning. The present invention may be best understood with reference to the claims.

Below, the present invention will be described more specifically by using examples.

### Example 1

### Pretreatment

An electrodeposited copper foil having thickness of 18 µm, having M side with Rz of 1.1 µm, and having granular crystals was dipped in 1N hydrochloric acid (35%) at ordinary temperature.

### Roughening Treatment

As roughening treatment, burnt plating and the encapsulation plating were performed.
Burnt plating solution composition
- Cu:: 25 g/L
- Sulfuric acid:: 130 g/L
- Other ingredient:: Mo
Burnt plating condition
- Current density:: 30 A/dm²
- Treatment time:: 10 sac
Encapsulation plating solution composition
- Cu:: 70 g/L
- Sulfuric acid:: 100 g/L
Encapsulation plating condition
- Current density:: 15 A/dm²
- Treatment time:: 10 sec.

The Rz of M side after roughening treatment was 1.9 µm.

Next, the entire S side and M side except for 10 x 10 cm square section were masked. A resistance layer was formed by using platinum-plated titanium plate having surface area of 1.5 dm² as the anode under the following conditions:
- NiSO₄·6H₂O:: 150 g/L
- NiCl₂·6H₂O:: 45g/L
- NiCO₃:: 15 g/L

- H₃PO₄:: 50 g/L
- H₃PO₃:: 40 g/L
- Bath temperature:: 65°C
- Current density:: 15 A/dm²
- Time:: 30 sec
- pH:: 1.0

After the plating, evenness of appearance of plating of resistance layer, plating thickness as constituted by the amount of deposition of Ni (mg/dm²), content of P (%), and resistance value at 1 mm square area after circuit formation were measured. The results are shown in Table 1.

### Example 2

Electrodeposited copper foil the same as that of Example 1 was roughening treated in the same way as in Example 1, then plated to form a resistance layer in the following bath:
- Nickel sulfamate:: 350g/L
- H₃BO₃:: 35 g/L
- H₃PO₄:: 50 g/L
- H₃PO₃:: 40 g/L
- Bath temperature :: 75°C
- Current density:: 5 A/dm²
- Time:: 18 sec
- pH:: 1.1

After the plating, evenness of appearance of plating of resistance layer, plating thickness as constituted by the amount of deposition of Ni (mg/dm²), content of P (%), and resistance value at 1 mm square after circuit formation were measured. The results are shown in Table 1.

### Example 3

Electrodeposited copper foil having thickness of 12 µm, having M side with Rz of 1.5 µm, and having granular crystals was used and roughening treated on its M side in the same way as in Example 1 to give Rz of 2.4 µm, then was plated to form resistance layer in the following bath:
- NiSO₄·6H₂O:: 150 g/L
- NiCl₂·6H₂O:: 45g/L
- H₂SO₄:: 5 g/L
- H₃PO₄:: 50 g/L

- H₃PO₃:: 40 g/L
- Bath temperature:: 65°C
- Current density:: 25 A/dm²
- Time:: 20 sec
- pH:: 1.1

After the plating, evenness of appearance of plating of the resistance layer, plating thickness as constituted by the amount of deposition of Ni (mg/dm²), content of P (%), and resistance value at 1 mm square area after circuit formation were measured. The results are shown in Table 1.

### Example 4

Resistance layer was formed under similar conditions as in Example 2 except for changing the current density and plating time as follows:
- Current density:: 15 A/dm²
- Time:: 32 sec

After the plating, evenness of appearance of plating of the resistance layer, plating thickness as constituted by the amount of deposition of Ni (mg/dm²), content of P (%), and resistance value at 1 mm square area after circuit formation were measured. The results are shown in Table 1.

### Example 5

Resistance layer was formed under similar conditions as in Example 1 except for changing the current density and plating time as follows:
- Current density:: 5 A/dm²
- Time:: 8 sec

After the plating, evenness of appearance of plating of the resistance layer, plating thickness as constituted by the amount of deposition of Ni (mg/dm²), content of P (%), and resistance value at 1 mm square after circuit formation were measured. The results are shown in Table 1.

### Example 6

Resistance layer was formed under similar conditions as in Example 2 except for changing the current density and plating time as follows:
- Current density:: 15 A/dm²
- Time:: 45 sec

After the plating, evenness of appearance of plating of the resistance layer, plating thickness as constituted by the amount of deposition of Ni (mg/dm²), content of P (%), and resistance value at 1 mm square after circuit formation were measured. The results are shown in Table 1.

### Example 7

The resistance layer was formed under similar conditions as in Example 1 except for changing the current density and plating time as follows:
- Current density:: 5 A/dm²
- Time:: 3 sec

After the plating, evenness of appearance of plating of the resistance layer, plating thickness as constituted by the amount of deposition of Ni (mg/dm²), content of P (%), and resistance value at 1 mm square after circuit formation were measured. The results are shown in Table 1.

### Comparative Example 1

Electrodeposited copper foil having thickness of 18 µm, having M side with Rz of 5.1 µm, and having columnar crystals was pretreated and roughening treated in the same way as in Example 1 to obtain Rz of the M side of 6.5 µm, then was masked over the entire S side and the M side except for 10 x 10 cm square section and formed with resistance layer by using platinum-plated titanium plate having surface area of 1.5 dm² as the anode under the following conditions:
- NiSO₄·6H₂O:: 150 g/L
- NiCl₂·6H₂O:: 45g/L
- NiCO₃:: 15 g/L
- H₃PO₄:: 50 g/L
- H₃PO₃:: 40 g/L
- Bath temperature:: 65°C
- Current density:: 15 A/dm²
- Time:: 30 sec
- pH:: 1.0

After the plating, evenness of appearance of plating of resistance layer, plating thickness as constituted by the amount of deposition of Ni (mg/dm²), content of P (%), and resistance value at 1 mm square after circuit formation were measured. The results are shown in Table 1.

### Comparative Example 2

Electrodeposited copper foil having thickness of 12 µm, having M side with Rz of 2.3 µm, and having columnar crystals was pretreated and roughened in the same way as in Example 1 to obtain Rz of 2.5 µm, then was masked over the entire S side and the M side except for 10 x 10 cm square section and formed with resistance layer on the M side using platinum-plated titanium plate having surface area of 1.5 dm² as the anode and using similar bath to Example 2 but changing the current density and plating time as follows:
- Current density:: 6 A/dm²
- Time:: 90 sec
After the plating, evenness of appearance of plating of the resistance layer, plating thickness as constituted by the amount of deposition of Ni (mg/dm²), content of P (%), and resistance value at 1 mm square area after circuit formation were measured. The results are shown in Table 1.

### Comparative Example 3

Resistance layer was formed under similar conditions as in Example 1 except for changing the current density and plating time as follows:
- Current density:: 35 A/dm²
- Time:: 15 sec

After the plating, evenness of appearance of plating of the resistance layer, plating thickness as constituted by the amount of deposition of Ni (mg/dm²), content of P (%), and resistance value at 1 mm square after circuit formation were measured. The results are shown in Table 1.

### Comparative Example 4

Electrodeposited copper foil having thickness of 18 µm, having M side with Rz of 1.1 µm, and having granular crystals was roughened to obtain Rz of 3.0 µm, then was masked over the entire S side and the M side except for a 10 x 10 cm square section and formed with resistance layer on the M side using platinum-plated titanium plate having surface area of 1.5 dm² as the anode under similar conditions to Example 1.

After the plating, evenness of appearance of plating of the resistance layer, plating thickness as constituted by the amount of deposition of Ni (mg/dm²), content of P (%), and resistance value at 1 mm square area after circuit formation were measured. The results are shown in Table 1.

In Table 1, the "average thickness" indicates the amount of deposition of Ni (mg/dm²). Note that Ni of 89 mg/dm² corresponds to about 1 µm.

The plating thickness was measured by dissolving the surface to measure the amounts of deposition of Ni and P and preparing calibration curve by fluorescent X-rays based on the same. Therefore, the value is for apparent surface area.

The "variation of resistance value after etching (3σ)" is the difference (variation %) compared with the average of measurement of 2 times (n=2) for each 10 plated copper foils of respective conditions (in total N=20).

The conductive base material with resistance layer formed in each of the examples and comparative examples was covered on its resistance layer side formed by the plating with glass fiber impregnated with epoxy resin, the hot-pressed and bonded by lamination press to thereby obtain printed board with resistance layer. Then, each board was etched using Neutra-Etch V-1 made by Shipley at 52°C (for 1 to 2 min) until the copper color disappeared. The resistance layer was etched by 250 g/L of copper sulfate and 5 g/L of sulfuric acid at 90°C. The unit of the resistance value was
Ω/mm².

**Table 1**

| Sample | Average thickness of resistance layer | | Resistance and variation after etching (Ω/mm²) | Evenness of appearance of plating |
|---|---|---|---|---|
| | Ni deposition(mg/dm²) | P content (%) | | |
| Ex. 1 | 13 | 11 | 25±10% | Good |
| Ex. 2 | 5 | 13 | 73±11% | Good |
| Ex. 3 | 13 | 8 | 26±12% | Good |
| Ex. 4 | 19 | 15 | 15±12% | Good |
| Ex. 5 | 1 | 18 | 151±19% | Good |
| Ex. 6 | 25 | 11 | 10± 6% | Good |
| Ex. 7 | 0.3 | 14 | 250±25% | Good |
| Comp. Ex. 1 | 13 | 12 | 33±54% | Poor |
| Comp. Ex. 2 | 13 | 11 | 24±39% | Poor |
| Comp. Ex. 3 | 13 | 5 | 12±42% | Good |
| Comp. Ex. 4 | 13 | 12 | 27±42% | Fair |

As clear from Table 1, the evenness of appearance is uniform in the examples of the invention. However, Comparative Examples 1, 2 and 4 exhibited striped appearances along the direction of flow of the plating solution and suffered from variations in plating thickness causing variations in the resistance values.

Looking at the resistance values and variations after etching, there was little variation, that is, not more than ±25%, in the examples of the invention. In Comparative Examples 1, 2, and 4, however, the Rz's after roughening treatment were 2,5 µm or more with large variation. In Comparative Example 3, the P content was low suggesting easy dissolution of the Ni-P layer during etching, consequently resulting in the large variation of resistance value. In Comparative Example 2, the Rz after roughening treatment was low due to the granular crystals and the peel strength was unsatisfactory.

As described above, therefore, Examples 1 to 7 exhibited small variation of resistance value and superior uniformity.

From the above results, it is clear that the present invention can produce and provide conductive base material with resistance layer able to give good and uniform appearance, small variation of resistance value, superior peel strength to provide excellent circuit board material with resistance layer using the same.

It should be understood by those skilled in the art that various modifications, combinations, subcombinations and alterations may be executed depending on design requirements and other factors in so far as they are within scope of the appeared claims or the equivalents thereof.

## Claims

1. A conductive base material with resistance layer comprising:
electrodeposited copper foil having granular crystals and roughening treated on at least one surface to Rz of not more than 2.5 µm and
the resistance layer of Ni alloy containing at least 8 to 18 wt% of P formed on the roughening treated side.

2. A conductive base material with resistance layer as set forth in claim 1, wherein the thickness of the resistance layer of the Ni alloy is 0.1 to 20 mg/dm² in weight conversion.

3. A circuit board material with resistance layer comprising:
conductive base material with the resistance layer including
electrodeposited copper foil having granular crystals and roughening treated on at least one surface to Rz of not more than 2.5 µm and
the resistance layer of Ni alloy containing at least 8 to 18 wt% of P formed on the roughening treated side and
insulation board to at least one surface of which said base material is bonded with the resistance layer at its inside surface.

4. A conductive board material with resistance layer as set forth in claim 3, wherein the thickness of resistance layer of Ni alloy is 0.1 to 20 mg/dm² in weight conversion.
